# EUROPEAN PATENT APPLICATION

(11) **EP 4 794 229 A2**
(43) Date of publication of application: **19.08.2026**
(21) Application number: 23956211.9
(22) Date of filing: 27.10.2023
(51) Int. Cl.: H04L 1/00

(54) **ENCODING/DECODING METHOD AND APPARATUS INCLUDING CRC ADDITION FOR STAIRCASE CODE IN WIRELESS COMMUNICATION SYSTEM**

(30) Priority: 20.10.2023 KR 20230141567
(71) Applicant: Samsung Electronics Co., Ltd., Suwon-si, Gyeonggi-do 16677 (KR)
(72) Inventor: LEE, Donghun, Suwon-si Gyeonggi-do 16677 (KR); MYUNG, Seho, Suwon-si Gyeonggi-do 16677 (KR); KANG, Jaeeun, Suwon-si Gyeonggi-do 16677 (KR); LEE, Juho, Suwon-si Gyeonggi-do 16677 (KR); JANG, Min, Suwon-si Gyeonggi-do 16677 (KR); JUNG, Jungsoo, Suwon-si Gyeonggi-do 16677 (KR); HAN, Donghwa, Suwon-si Gyeonggi-do 16677 (KR)
(74) Representative: Nederlandsch Octrooibureau
(86) International application number: PCT/KR2023/016931
(87) International publication number: WO 2025/084489

(57) **Abstract**

The present disclosure relates to an encoding/decoding method and apparatus including CRC addition for a staircase code. According to an embodiment of the present disclosure, the encoding method, performed by a transmission device in a wireless communication system, including CRC addition of a staircase code, comprises the steps of: inserting new information bits in a single layer or a plurality of layers of the staircase code; adding, to the new information bits, CRC bits generated by performing CRC encoding on a set of new information bits in the single layer or the plurality of layers; and transmitting, to a reception device, a staircase code codeword generated by performing row-wise encoding or column-wise encoding using an element code in each layer of the staircase code.

## Description

### [Technical Field]

The disclosure relates to a communication method and device using a staircase code in a wireless communication system.

### [Background Art]

Considering the development of wireless communication from generation to generation, the technologies have been developed mainly for services targeting humans, such as voice calls, multimedia services, and data services. Following the commercialization of 5G (5th-generation) communication systems, it is expected that the number of connected devices will exponentially grow. Increasingly, these will be connected to communication networks. Examples of connected things may include vehicles, robots, drones, home appliances, displays, smart sensors connected to various infrastructures, construction machines, and factory equipment. Mobile devices are expected to evolve in various form-factors, such as augmented reality glasses, virtual reality headsets, and hologram devices. In order to provide various services by connecting hundreds of billions of devices and things in the 6G (6th-generation) era, there have been ongoing efforts to develop improved 6G communication systems. For these reasons, 6G communication systems are referred to as beyond-5G systems.

6G communication systems, which are expected to be commercialized around 2030, will have a peak data rate of tera (1,000 giga)-level bps and a radio latency less than 100µsec, and thus will be 50 times as fast as 5G communication systems and have the 1/10 radio latency thereof.

In order to accomplish such a high data rate and an ultra-low latency, it has been considered to implement 6G communication systems in a terahertz band (for example, 95GHz to 3THz bands). It is expected that, due to severer path loss and atmospheric absorption in the terahertz bands than those in mmWave bands introduced in 5G, technologies capable of securing the signal transmission distance (that is, coverage) will become more crucial. It is necessary to develop, as major technologies for securing the coverage, radio frequency (RF) elements, antennas, novel waveforms having a better coverage than orthogonal frequency division multiplexing (OFDM), beamforming and massive multiple input multiple output (MIMO), full dimensional MIMO (FD-MIMO), array antennas, and multiantenna transmission technologies such as large-scale antennas. In addition, there has been ongoing discussion on new technologies for improving the coverage of terahertz-band signals, such as metamaterial-based lenses and antennas, orbital angular momentum (OAM), and reconfigurable intelligent surface (RIS).

Moreover, in order to improve the spectral efficiency and the overall network performances, the following technologies have been developed for 6G communication systems: a full-duplex technology for enabling an uplink transmission and a downlink transmission to simultaneously use the same frequency resource at the same time; a network technology for utilizing satellites, high-altitude platform stations (HAPS), and the like in an integrated manner; an improved network structure for supporting mobile base stations and the like and enabling network operation optimization and automation and the like; a dynamic spectrum sharing technology via collision avoidance based on a prediction of spectrum usage; an use of artificial intelligence (AI) in wireless communication for improvement of overall network operation by utilizing AI from a designing phase for developing 6G and internalizing end-to-end AI support functions; and a next-generation distributed computing technology for overcoming the limit of UE computing ability through reachable super-high-performance communication and computing resources (such as mobile edge computing (MEC), clouds, and the like) over the network. In addition, through designing new protocols to be used in 6G communication systems, developing mechanisms for implementing a hardware-based security environment and safe use of data, and developing technologies for maintaining privacy, attempts to strengthen the connectivity between devices, optimize the network, promote softwarization of network entities, and increase the openness of wireless communications are continuing.

It is expected that research and development of 6G communication systems in hyper-connectivity, including person to machine (P2M) as well as machine to machine (M2M), will allow the next hyper-connected experience. Particularly, it is expected that services such as truly immersive extended reality (XR), high-fidelity mobile hologram, and digital replica could be provided through 6G communication systems. In addition, services such as remote surgery for security and reliability enhancement, industrial automation, and emergency response will be provided through the 6G communication system such that the technologies could be applied in various fields such as industry, medical care, automobiles, and home appliances.

A staircase code is being studied as one of encoding schemes that may be used in next-generation communication systems such as a 5G communication system or a 6G communication system. The staircase code was first proposed in the optical communication field in 2012, and was introduced as a code that may guarantee excellent performance at a very high code rate using a Bose-Chaudhuri-Hocquenghem (BCH) code as a component code. The staircase code is known as a code having very excellent performance, especially when based on hard decision decoding (HDD), illustrating only a 0.56 dB difference from a theoretical performance limit of a bit error rate (BER) of 10-15.

### [Detailed Description of the Invention]

### [Technical Problem]

The disclosure provides a method and device for efficiently performing encoding/decoding including cyclic redundancy check (CRC) addition for a staircase code in a wireless communication system.

Further, the disclosure provides a method and device for performing CRC encoding for a staircase code on a single layer basis or a plurality of layers basis in a wireless communication system.

Further, the disclosure provides a method and device for adjusting a length of a CRC code in CRC encoding for a staircase code in a wireless communication system.

### [Technical Solution]

According to an embodiment of the disclosure, a method of encoding, including CRC (cyclic redundancy check) addition of a staircase code, performed by a transmitting device in a wireless communication system includes inserting new information bits in a single layer or a plurality of layers of the staircase code, performing CRC encoding on a set of new information bits in the single layer or the plurality of layers and adding generated CRC bits to the new information bits, and transmitting a staircase code codeword generated by performing row-wise encoding or column-wise encoding using a component code in each layer of the staircase code to a receiving device.

Further, according to an embodiment of the disclosure, a transmitting device performing encoding, including CRC addition of a staircase code, in a wireless communication system includes a transceiver, and a processor configured to insert new information bits in a single layer or a plurality of layers of the staircase code, perform CRC encoding on a set of new information bits in the single layer or the plurality of layers and add generated CRC bits to the new information bits, and transmit, through the transceiver, a staircase code codeword generated by performing row-wise encoding or column-wise encoding using a component code in each layer of the staircase code to a receiving device.

Further, according to an embodiment of the disclosure, a method of decoding a staircase code performed by a receiving device in a wireless communication system includes receiving, from a transmitting device, encoding-related configuration information including CRC addition of the staircase code, receiving an encoded staircase code codeword from the transmitting device, and recovering information bits by performing row-wise decoding or column-wise decoding using a component code in each layer of the staircase code based on the configuration information, and a decoding error for the staircase code codeword is detected using a single-layer-based CRC code or a multi-layer-based CRC code.

Further, according to an embodiment of the disclosure, a receiving device performing decoding of a staircase code in a wireless communication system includes a transceiver, and a processor configured to receive, through the transceiver, encoding-related configuration information including CRC addition of the staircase code from a transmitting device, receive, through the transceiver, an encoded staircase code codeword from the transmitting device, recover information bits by performing row-wise decoding or column-wise decoding using a component code in each layer of the staircase code based on the configuration information, and detect a decoding error for the staircase code codeword using a single-layer-based CRC code or a multi-layer-based CRC code.

### [Brief Description of Drawings]

FIG. 1A is a view illustrating an example configuration of a staircase code based on a square matrix,
FIG. 1B is a view illustrating an encoding method using the square matrix-based staircase code of FIG. 1A,
FIG. 2A is a view illustrating an example configuration of a staircase code based on a non-square matrix,
FIGS. 2B and 3 are views illustrating an encoding method using the non-square matrix-based staircase code of FIG. 2A,
FIG. 4 is a view illustrating a decoding method using a square matrix-based staircase code,
FIG. 5 is a view illustrating a decoding method using a non-square matrix-based staircase code,
FIG. 6 is a view illustrating an example of an encoding method including CRC addition for a square matrix-based staircase code according to an embodiment of the disclosure,
FIG. 7 is a view illustrating an example of an encoding method including CRC addition for a square matrix-based staircase code according to an embodiment of the disclosure,
FIG. 8 is a view illustrating an example of an encoding method including CRC addition for a non-square matrix-based staircase code according to an embodiment of the disclosure,
FIG. 9 is a view illustrating an example of an encoding method including CRC addition for a square matrix-based staircase code according to an embodiment of the disclosure,
FIGS. 10A, 10B, and 10C are views illustrating various methods of adjusting a length L' of a CRC code according to embodiments of the disclosure,
FIG. 11 is a view illustrating an example of an encoding method including CRC addition for a non-square matrix-based staircase code according to an embodiment of the disclosure,
FIG. 12 is a view illustrating a method of adjusting a length of a CRC code by considering a number of overlapping parts in each layer in a staircase code according to an embodiment of the disclosure,
FIG. 13A is a view illustrating an encoding method including CRC addition for a staircase code performed by a transmitting device of a wireless communication system according to an embodiment of the disclosure,
FIG. 13B is a view illustrating a decoding method for a staircase code performed by a receiving device of a wireless communication system according to an embodiment of the disclosure, and
FIG. 14 is a view illustrating an example configuration of a communication device in a wireless communication system according to an embodiment of the disclosure.

### [Mode for Carrying out the Invention]

Hereinafter, the operational principle of the disclosure is described below with reference to the accompanying drawings. When determined to make the subject matter of the present disclosure unclear, the details of the known functions or configurations may be skipped. Terms to be described below are terms defined considering functions in the disclosure, which may vary according to intentions or customs of users and operators. Therefore, the terms should be defined based on the overall disclosure.

For the same reasons, some elements may be exaggerated or schematically shown. The size of each element does not necessarily reflect the real size of the element. The same reference numeral is used to refer to the same element throughout the drawings.

Advantages and features of the present disclosure, and methods for achieving the same may be understood through the embodiments to be described below taken in conjunction with the accompanying drawings. However, the scope of the disclosure is not limited to embodiments described herein, but rather, other various changes may be made thereto. Various embodiments are provided for thorough disclosure of the present invention and making the category of the present invention known to one of ordinary skill in the art, and the present invention is defined only by the claims. The same reference numerals refer to the same components throughout the specification.

In this case, it will be understood that each block of the process flow diagrams and combinations of blocks in the flow diagrams may be performed by computer program instructions. Since the computer program instructions may be equipped in a processor of a general-use computer, a special-use computer or other programmable data processing devices, the instructions executed through a processor of a computer or other programmable data processing devices generate means for performing the functions described in connection with a block(s) of each flowchart. Since the computer program instructions may be stored in a computer-available or computer-readable memory that may be oriented to a computer or other programmable data processing devices to implement a function in a specified manner, the instructions stored in the computer-available or computer-readable memory may produce a product including an instruction means for performing the functions described in connection with a block(s) in each flowchart. Since the computer program instructions may be equipped in a computer or other programmable data processing devices, instructions that generate a process executed by a computer as a series of operational steps are performed over the computer or other programmable data processing devices and operate the computer or other programmable data processing devices may provide steps for executing the functions described in connection with a block(s) in each flowchart.

Further, each block may represent a module, segment, or part of a code including one or more executable instructions for executing a specified logical function(s). Further, it should also be noted that in some replacement embodiments, the functions mentioned in the blocks may occur in different orders. For example, two blocks that are consecutively shown may be performed substantially simultaneously or in a reverse order depending on corresponding functions.

As used herein, the term "...unit" means a software element or a hardware element. The '...unit' plays a certain role. However, 'unit' is not limited to software or hardware. A 'unit' may be configured in a storage medium that may be addressed or may be configured to execute one or more processors. Accordingly, as an example, a 'unit' includes elements, such as software elements, object-oriented software elements, class elements, and task elements, processes, functions, attributes, procedures, subroutines, segments of program codes, drivers, firmware, microcodes, circuits, data, databases, data architectures, tables, arrays, and variables. Functions provided within the components and the 'units' may be combined into smaller numbers of components and 'units' or further separated into additional components and 'units'. Further, the components and 'units' may be implemented to execute one or more CPUs in a device or secure multimedia card. Further, in various embodiments of the disclosure, a "...unit" may include one or more processors.

As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order).

In embodiments of the disclosure, a user equipment (UE) may be a terminal, a mobile station (MS), a cellular phone, a smartphone, a computer, or various electronic devices capable of performing a communication function. Further, a base station (BS) is a network entity performing resource allocation to a terminal, and may be at least one of a Node B, an eNB (eNode B), a gNB (gNode B), a wireless access unit, a base station controller, or a node on a network.

Further, various embodiments of the disclosure may be applied to other communication systems having similar technical backgrounds or channel forms as various embodiments of the disclosure described below. Further, various embodiments of the disclosure may be modified in such a range as not to significantly depart from the scope of the disclosure under the determination by one of ordinary skill in the art and such modifications may be applicable to other communication systems.

In describing various embodiments of the disclosure in detail, a communication system may use a wireless communication system, e.g., a 5G communication system based on 5G communication specifications (NR (New RAN)) proposed by 3GPP (3rd generation partnership project long term evolution), which is a wireless communication specification standardization body. Further, the disclosure may be applied to other communication systems having similar technical backgrounds with slight modifications within a range that does not significantly depart from the scope of the disclosure, and this is possible as judged by those skilled in the art. For convenience of description below, terms and names defined in 3GPP specifications may be partially used. However, the disclosure is not limited by the terms and names, and may be equally applied to systems conforming to other specifications.

A staircase code is described first to aid understanding of embodiments of the disclosure. The staircase code may be regarded as a kind of product code having characteristics of both a block code and a convolutional code. This may be easily understood through the structure of the staircase code, where one layer of a stair is formed by stacking M codewords of the same length encoded with a predetermined component code (e.g., a linear code including a low density parity check (LDPC) code or a polar code) as row/column vectors in sequence to form a matrix.

Further, by regarding the rightmost M columns/rows of the codewords constituting the staircase code as rows/columns, adding new information bits to each row, and performing encoding with the component code in the same manner, a layer composed of new M codewords may be formed. Thereafter, when the same operation is repeated in reverse when forming a next layer of the staircase code, and this process is repeated k times for a number of layers, a staircase code having k layers may be generated.

Here, double encoding proceeds on M overlapping rows (or columns) between adjacent layers of the staircase code and, when a hard decision estimated value in the case of hard decision decoding or a log likelihood ratio (LLR) value in the case of soft decision decoding (SDD) is transferred to an overlapping part of an adjacent layer through individual decoding in each layer, a decoding error rate performance gain is present therefrom. Further, the staircase code is a code having an advantage that complete parallelization of decoding of codewords corresponding to each row of a specific layer is possible, and parallelization of decoding for non-adjacent layers is also possible as needed, so a tradeoff between error rate performance and decoding delay during decoding may be adjusted.

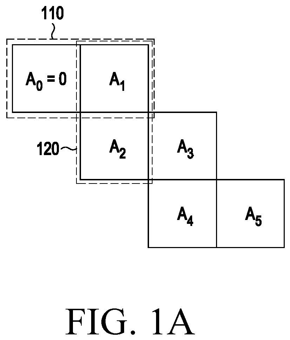

An encoding/decoding method of a staircase code based on a square matrix or a non-square matrix is described below with reference to FIGS. 1A to 4. Table 1 below defines parameters referenced in the description of the staircase code.

**[Table 1]**

| Parameters of staircase code | Definition |
|---|---|
| C | component code (e.g., LDPC code, polar code, linear code such as BCH code) |
| k | number of layers (or stairs) of staircase code |
| M | number of rows (or columns) of layer / size of overlapping part |
| Kc or K | number of information bits of component codeword |
| Nc or N | code length of component codeword |
| Ktot | total number of information bits of staircase code codeword |
| Ntot | total code length of staircase code codeword |
| r | number of parity bits of component codeword |
| L or L' | length of CRC code |

First, the staircase code may be divided into two types: a staircase code based on a square matrix and a staircase code based on a non-square matrix (or fat matrix). Hereinafter in the disclosure, during encoding at a transmitting device, a square matrix constituting the staircase code is denoted as "A", and a non-square matrix is denoted as "B". Further, during decoding at a receiving device, a square matrix constituting the staircase code is denoted as "X", and a non-square matrix is denoted as "Y". In the following embodiments, in a square matrix-based staircase code, a first layer includes an initial matrix and one square matrix, and each of the remaining layers includes an overlapping part with a previous layer (e.g., a square matrix) and one square matrix. In a non-square matrix-based staircase code, a first layer includes an initial matrix and one non-square matrix, and the remaining layers include an overlapping part with a previous layer (e.g., a square matrix) and one non-square matrix. When the overlapping part is regarded as one matrix, it may be understood that each layer in a square matrix-based or non-square matrix-based staircase code includes two matrices. Further, in a square matrix-based or non-square matrix-based staircase code, the number of matrices included in each of the remaining layers may be one or more. When the number of matrices included in each layer is one, it may be understood that the matrix includes the overlapping part.

FIG. 1A is a view illustrating an example configuration of a staircase code based on a square matrix.

Referring to FIG. 1A, a square matrix is a matrix in which a number of rows and a number of columns are the same, and FIG. 1A illustrates a staircase code based on a square matrix with a number of layers (k) of 5. Referring to FIG. 1A, e.g., a staircase code composed of six square matrices A₀, A₁, A₂, A₃, A₄, A₅ having a size of M×M is illustrated, but if the number of matrices is 3 or more, a staircase code including an overlapping part may be formed. The number of layers 5 represents an example and may be 2 or more. In the example of FIG. 1A, two square matrices A₀, A₁ form a first layer 110 in the staircase code, two square matrices A₁, A₂ form a second layer 120, and in the same manner, a staircase code having multiple layers (or stairs) such as a third layer, a fourth layer, and a fifth layer may be formed. Further, the first layer and the second layer have an overlapping part of A₁, and the second layer and the third layer have an overlapping part of A₂. In the same manner, other layers may also have overlapping parts. Decoding reliability may be enhanced through the overlapping part(s) in the staircase code. In the staircase code, elements of a first matrix (or initial matrix) A₀ may all be filled with values of 0 (or predetermined values), e.g., and may represent a starting point of the staircase code. A square matrix-based staircase code as in FIG. 1A has low complexity in encoding/decoding, so a transmitting device and a receiving device using the staircase code may be implemented with low complexity.

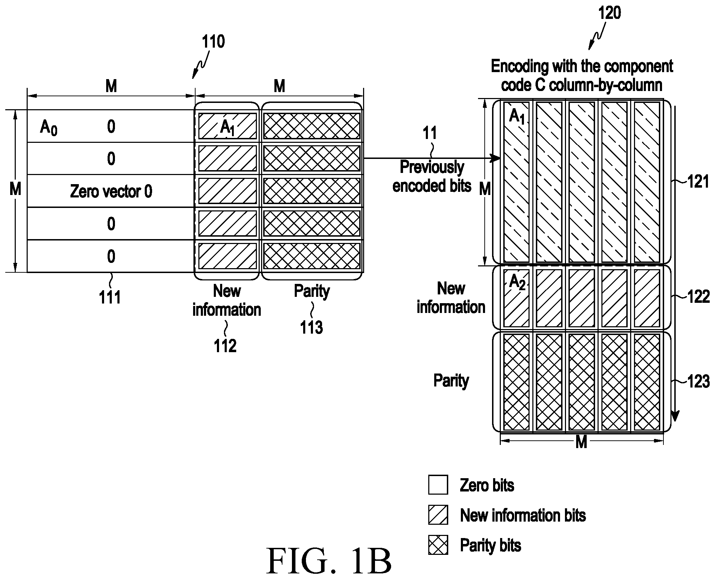

FIG. 1B is a view illustrating an encoding method using the square matrix-based staircase code of FIG. 1A.

In the example of FIG. 1B, a first layer 110 of the staircase code includes a matrix A₀ 111 of M×M size and a matrix A₁ of M×M size. All elements of the matrix A₀ have a value of 0 (or a predetermined value), e.g., and the matrix A₁ includes an information part 112 and a parity part 113. Further, new information bits are filled in the information part 122. For example, the parity part 113 may be filled through row-wise encoding for each of the 5 rows of the first layer 110. In other words, parity bits are generated by performing encoding using a component code C such as an LDPC code, a polar code, or a BCH code row-by-row for information bits of each row of the matrix A₀ and the matrix A₁ of the first layer 110, and the parity bits are filled in the corresponding row of the parity part 113.

In the example of FIG. 1B, a second layer 120 of the staircase code includes a matrix A₁ 121 of M×M size and a matrix A₂ of M×M size. The second layer 120 includes the matrix A₁ and the matrix A₂, and the matrix A₁ corresponds to an overlapping part of the first layer 110 and the second layer 120. The matrix A₂ of the second layer 120 includes an information part 122 and a parity part 123. Further, new information bits are filled in the information part 122. For example, the parity part 123 may be filled through column-wise encoding for each of the 5 columns of the second layer 120. Parity bits are generated by performing encoding using a component code C such as an LDPC code, a polar code, or a BCH code column-by-column for information bits of each column of the matrix A₁ and the matrix A₂ of the second layer 120, and the parity bits are filled in the corresponding column of the parity part 123.

As described above, an encoding method using a square matrix-based staircase code performs row-wise encoding or column-wise encoding in an alternating manner in units of layers composed of, e.g., two square matrices, and adjacent layers have one square matrix as an overlapping part. In the case of a square matrix-based staircase code, a code length N_{C} of a component codeword in each layer composed of 2 matrices becomes simply 2 times M, and a number of information bits K_{C} may be simply calculated as (2M-r). Here, r is a number of parity bits of the component codeword. As a generalized example, in the square matrix-based staircase code, the two matrices constituting each layer may be referred to as a first matrix and a second matrix and, when n is 2 or more, the first matrix in an nth layer overlaps the second matrix in an n-1th layer, and the first matrix in an (n+1)th layer overlaps the second matrix in the nth layer.

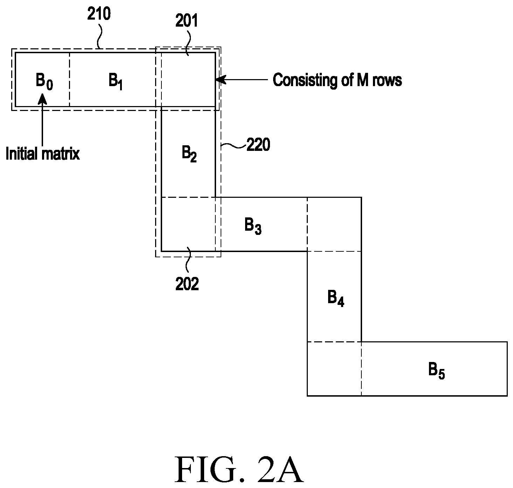

FIG. 2A is a view illustrating an example configuration of a staircase code based on a non-square matrix.

Referring to FIG. 2A, a non-square matrix is a matrix in which a number of rows and a number of columns are different, and FIG. 2A illustrates a staircase code based on a non-square matrix with a number of layers (k) of 5. Referring to FIG. 2A, a staircase code composed of a first matrix (initial matrix) B₀ of M×M size and a plurality of non-square matrices B₁, B₂, B₃, B₄, B₅ of M×(N-M) or (N-M)×M size is illustrated, e.g., but if the number of matrices constituting the staircase code is 3 or more, a staircase code including overlapping parts between adjacent layers may be formed. In FIG. 2A, a first layer 210 of the staircase code includes a matrix B₀ and a matrix B₁, a second layer 220 includes at least a part 201 of the matrix B₁ and a matrix B₂, and a third layer includes at least a part of the matrix B₂ and a matrix B₃. Further, the second layer 220 includes at least the part 201 of the matrix B₁ and the matrix B₂, and the third layer may include at least the part 202 of the matrix B₂ and the matrix B₃. In the same manner, a staircase code having multiple layers (or stairs) such as a fourth layer and a fifth layer may be formed. In FIG. 2A, the first layer 210 and the second layer 220 have an overlapping part 201 corresponding to at least a part of the matrix B₁, and the second layer 220 and the third layer have an overlapping part 202 corresponding to at least a part of the matrix B₂. In the same manner, other layers may also have overlapping parts. Decoding reliability may be enhanced through the overlapping part(s) in the staircase code.

In FIG. 2A, it is assumed that the overlapping part has a size of M×M as an example. In the staircase code, elements of a first matrix (initial matrix) B₀ may all be filled with values of 0 (or predetermined values), e.g., and may represent a starting point of the staircase code. A non-square matrix-based staircase code as in FIG. 2A has low complexity in encoding/decoding, so a transmitting device and a receiving device using the staircase code may be implemented with low complexity. As a generalized example, in the non-square matrix-based staircase code, the two matrices constituting each layer may be referred to as a first matrix and a second matrix, and the second matrix uses a non-square matrix. When n is 2 or more, the first matrix in an nth layer overlaps at least a part of the second matrix in an n-1th layer, and the first matrix in an (n+1)th layer overlaps at least a part of the second matrix in the nth layer. Further, a first matrix (initial matrix) of the staircase code and the first matrix corresponding to an overlapping part when n is 2 or more may use a square matrix. As an optional embodiment, at least one of the first matrix (initial matrix) and the first matrix corresponding to the overlapping part may be configured as a non-square matrix.

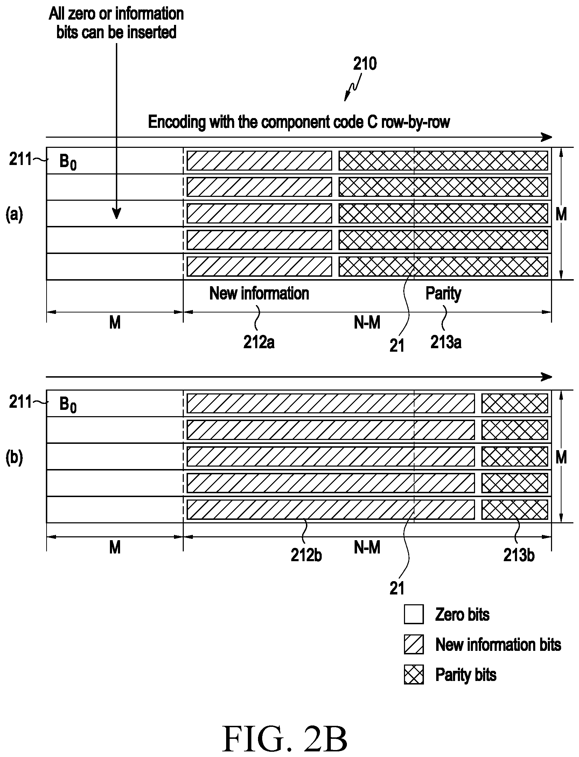

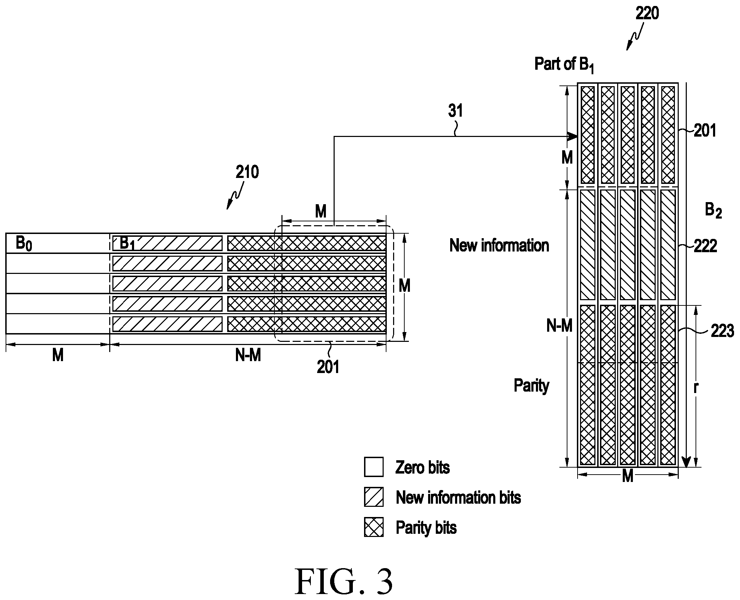

FIGS. 2B and 3 are views illustrating an encoding method using the non-square matrix-based staircase code of FIG. 2A.

InFIGS. 2B , a first layer 210 of the staircase code includes a matrix B₀ 211 of M×M size and a matrix B₁ of M×(N-M) size. All elements of the matrix B₀ have a value of 0, e.g., and the matrix B₁ includes an information part 212a or 212b and a parity part 213a or 213b. FIG. 2B(a) illustrates a case where the parity part 213a is larger than the information part 212a, and FIG. 2B(b) illustrates a case where the information part 212b is larger than the parity part 213b. New information bits are filled in the information part 212a or 212b. For example, the parity part 213a or 213b may be filled through row-wise encoding for each of the 5 rows in the first layer 210. In FIGS. 2B , the reference numeral 21 indicated by a dashed line illustrates a boundary line of an overlapping part between the first layer 210 and a second layer 220. Parity bits are generated by performing encoding using a component code C such as an LDPC code, a polar code, or a BCH code row-by-row for information bits of each row in the matrix B₀ and the matrix B₁, and the parity bits are filled in the corresponding row of the parity part 213a or 213b. Further, as in the example of FIGS. 2B , a case where information bits and parity bits are mixed (FIG. 2B(b)) and a case where only parity bits are present (FIG. 2B(a)) may be considered in an overlapping part between adjacent layers in the staircase code.

The example of FIG. 3 illustrates an encoding method performed in the second layer 220 of the staircase code, assuming a case where the parity part 213a is larger than the information part 212a as in the example of FIG. 2B(a) for convenience of description. The method of FIG. 3 may be equally applied in the example of FIG. 2B(b). Referring to FIG. 3, the second layer 220 of the staircase code includes at least a part 201 of the matrix B₁ and a matrix B₂ of (N-M)×M size. The at least part 201 corresponding to an overlapping part between the first layer 210 and the second layer 220 in the staircase code is a matrix having a size of M×M, and the matrix B₂ includes an information part 222 and a parity part 223. New information bits are filled in the information part 222. For example, the parity part 223 may be filled through column-wise encoding for each of the 5 columns in the second layer 220. Parity bits are generated by performing encoding using a component code C such as an LDPC code, a polar code, or a BCH code column-by-column for information bits of each column of the overlapping part 201 and the matrix B₂, and the parity bits are filled in the corresponding column of the parity part 223. The overlapping part 201 may be virtually rotated by, e.g., 90 degrees together with the matrix B₂ during encoding. As in the method described above, an encoding method using a non-square matrix-based staircase code performs row-wise encoding or column-wise encoding in an alternating manner, and adjacent layers have at least a part of the non-square matrix as an overlapping part.

In the case of a non-square matrix-based staircase code in the disclosure, since N_{C} and K_{C} may not be represented only by a relationship between M and r in Table 1 above, a number of information bits and a code length of a component codeword are separately indicated. Further, in the case of a square matrix-based staircase code, N_{C} and K_{C} may not be separately indicated.

Specifically describing the encoding method using a non-square matrix-based staircase code in the example of FIG. 3, first, elements of an initial matrix B₀ of M×M size are filled with 0 meaning that no information is carried, or may be filled with information bits. In the case of a square matrix-based staircase code, matrices *Bᵢ*, *i* = 0, 1, ..., *k* in all layers are composed of square matrices of M×M size, but in the case of a non-square matrix-based staircase code, the initial matrix B₀ of the first layer is composed of a square matrix of M×M size, and the remaining matrices *Bᵢ, i* = 1, 2, ..., *k* in each layer of the staircase code may be composed of non-square matrices of M×(N-M) or (N-M)×M size.

Step 1: To form a matrix Bᵢ (i=1, 2, ..., k) constituting the staircase code, first, a total of M(N-M-r) information bits may be inserted in row-wise or column-wise or in any method or order into the left (N-M-r) columns of Bᵢ. Here, r is a number of parity bits. The example of FIG. 3 assumes a case where row-wise encoding is performed in the matrix Bᵢ. Although not illustrated in FIG. 3, column-wise encoding may be performed in the matrix Bᵢ, and in this case, the encoding operation in Steps 2 and 3 below may be performed in reverse of the operation when row-wise encoding is performed in the matrix Bᵢ in Step 1.

Step 2: Thereafter, by treating M bits corresponding to the overlapping part 201 with the matrix Bᵢ₋₁ of a previous layer as information bits in each row, r parity bits 223 may be generated column-wise or row-wise by performing encoding using the component code C for a total of (N-r) information bits including newly inserted 31 information bits 222. A new layer (stair) (or matrix) may be generated by applying the corresponding operation equally to all rows.

Step 3: From the second layer, operations may be divided into two according to a layer index (stair index) i. For example, when i is even, the rightmost M columns of the matrix Bᵢ₋₁ of a previous layer may be virtually rotated by 90° counterclockwise. In other words, an overlapping part may be configured with the rightmost column as the topmost row. Based on the matrix composed of M rows thus created, the operations of Steps 1 and 2 above may be performed to generate the matrix Bᵢ on the right side. The matrix Bᵢ of the new layer generated in this manner is attached to the lower surface of the rightmost M columns of the matrix Bᵢ₋₁ of the previous layer in the original structure before virtual rotation. Further, when the layer index i is even, since a previous layer is a layer where row-wise encoding was performed, for encoding in a next layer, for the rightmost M columns of the previous layer, the first row of the next layer may be configured starting from the rightmost column, and a total of M columns of the previous layer may be rotated in order to become M rows of the next layer.

When the layer index i is odd, the operations of Steps 1 and 2 above may be performed to generate the matrix Bᵢ on the right side based on the bottom M rows of the matrix Bᵢ₋₁ of the previous layer. When the layer index is i, row-wise encoding may be performed directly on the bottom M rows of the previous layer (i-1), and in this case, an operation such as 90-degree rotation is not required.

Step 4: When the operations of Steps 1 to 3 above are repeated a total of k times, a staircase code composed of k layers may be generated.

The encoding method using an overlapping part and virtual rotation in Steps 1 to 4 above may be applied in the same manner to a square matrix-based staircase code.

From the codeword of the staircase code generated in the manner described above, when no information is carried in the initial matrix B₀ of the first layer, a codeword obtained by reading all bits of the matrix B₁ in the first layer except for the initial matrix B₀ and the matrices B₂, B₃, ... in the remaining layers as a row or column vector regardless of order may be defined as a final codeword. As an optional embodiment, when information bits are included in the initial matrix B₁ in the first layer, a codeword obtained by reading all bits of all matrices B₀, B₁, B₂, B₃, ... including the initial matrix B₀ in the first layer and the remaining layers as a row or column vector regardless of order may be defined as a final codeword. This definition may be applied to both a square matrix-based staircase code and a non-square matrix-based staircase code.

Hereinafter, for convenience, it is assumed in the description of the disclosure that information bits are not included in the initial matrix B₀, and for example, values of 0 are filled.

Table 2 below illustrates a code rate (R_{C}) of a component codeword and a total code rate (Rₜₒₜ) of the staircase code in the non-square matrix-based staircase code described above.

**[Table 2]**

| | Square matrix case (N=2M) | Fat matrix case (N>>M) |
|---|---|---|
| COMPONET CODE PERSPECTIVE | ${R}_{c} = \frac{K}{N} = \frac{2 M - r}{2 M} = 1 - \frac{r}{2 M}$ | ${R}_{c} = \frac{K}{N} = \frac{N - r}{N} = 1 - \frac{r}{N}$ |
| TOTAL CODE PERSPECTIVE | ${R}_{c} = \frac{kM \left(M-r\right)}{{kM}^{2}} = 1 - \frac{r}{M}$ | ${R}_{c} = \frac{kM \left(N-M-r\right)}{kM \left(N-M\right)} = 1 - \frac{r}{N - M}$ |

In the case of a non-square matrix-based staircase code, a total code length Nₜₒₜ of the codeword may be calculated as kM(N-M), and in the case of a square matrix-based staircase code, it may be represented in a simpler form as kM². A number of information bits may be represented as kM(N-r) in the case of a non-square matrix-based staircase code or kM(M-r) in the case of a square matrix-based staircase code. In the case of a square matrix-based staircase code, comparing a code rate ${R}_{c} = 1 - \frac{r}{N}$ of a component codeword and a total code rate ${R}_{tot} = \frac{N - r}{N - M}$, it may be identified that the code rate of the component codeword is higher. In other words, when the code rate of the entire codeword of the staircase code is increased, the code rate of the component codeword increases to a larger value, which greatly affects the performance of the component code.

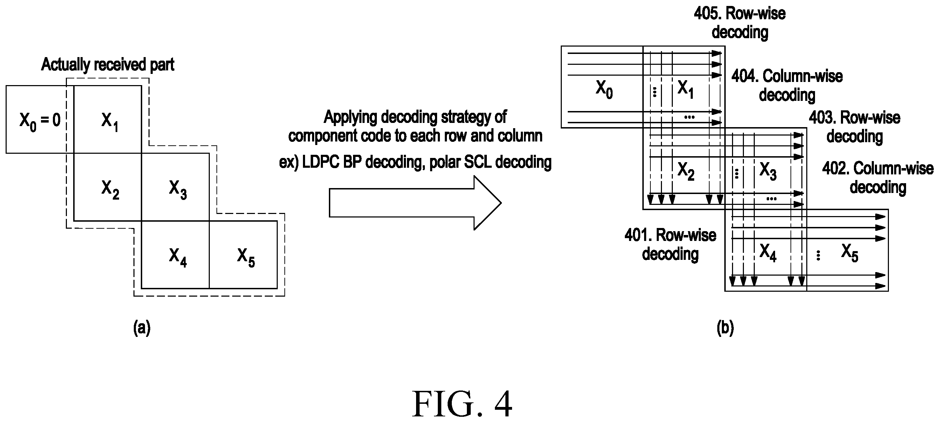

FIG. 4 is a view illustrating a decoding method using a square matrix-based staircase code.

A square matrix-based staircase code may be encoded by the encoding method of FIG. 1B as described above, and may be decoded by the decoding method of FIG. 4. Decoding may use decoding using a component code C such as an LDPC code, a polar code, or a BCH code used during encoding.

First, it is assumed that a transmitting device encodes and transmits a staircase code composed of a plurality of square matrices A₀, A₁, A₂, A₃, A₄, A₅ having a size of M×M using a square matrix-based staircase code with a number of layers (k) of 5 as in the examples of FIGS. 1A and 1B. A receiving device may receive/obtain a staircase code composed of 6 square matrices X₀, X₁, X₂, X₃, X₄, X₅ having a size of M×M as in FIG. 4(a). In this case, if the initial matrix A₀ has, e.g., a value of 0 (or a predetermined value), what is actually received at the receiving device is a staircase code of 5 square matrices X₁, X₂, X₃, X₄, X₅, and the receiving device fills the initial matrix X₀ of the staircase code with a value of 0 (or a predetermined value) like the initial matrix A₀. As in FIG. 4(b), the receiving device performs row-wise decoding on the matrices X₄, X₅ of the fifth layer in step 401, performs column-wise decoding on the matrices X₃, X₄ of the fourth layer in step 402, and in the same manner, alternately performs row-wise decoding or column-wise decoding on the third layer to the first layer in steps 403 to 405 to decode information bits. Further, as an optional example, it is also possible to alternately perform row-wise decoding or column-wise decoding in order from the first layer to the fifth layer in reverse order of FIG. 4(b)to decode information bits.

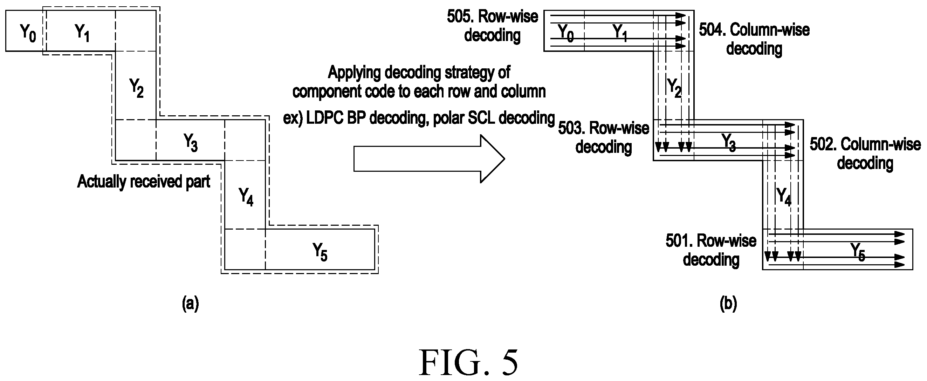

FIG. 5 is a view illustrating a decoding method using a non-square matrix-based staircase code.

A non-square matrix-based staircase code may be encoded by the encoding method of FIG. 3 as described above, and may be decoded by the decoding method of FIG. 5. Decoding may use decoding using a component code C such as an LDPC code, a polar code, or a BCH code used during encoding.

First, it is assumed that a transmitting device encodes and transmits a staircase code composed of a first matrix (initial matrix) B₀ of M×M size and 5 non-square matrices B₁, B₂, B₃, B₄, B₅ of M×(N-M) or (N-M)×M size as a non-square matrix-based staircase code with a number of layers (k) of 5 as in the examples of FIGS. 2A to 3. A receiving device may receive/obtain a first matrix (initial matrix) Y₀ of M×M size and 5 non-square matrices Y₁, Y₂, Y₃, Y₄, Y₅ of M×(N-M) or (N-M)×M size as in FIG. 5(a). In this case, if the initial matrix B₀ has, e.g., a value of 0 (or a predetermined value), what is actually received at the receiving device is a staircase code of 5 non-square matrices Y₁, Y₂, Y₃, Y₄, Y₅, and the receiving device fills the initial matrix Y₀ of the staircase code with a value of 0 (or a predetermined value) like the initial matrix B₀. As in FIG. 5(b), the receiving device performs row-wise decoding on the matrices Y₄, Y₅ of the fifth layer in step 501, performs column-wise decoding on the matrices Y₃, Y₄ of the fourth layer in step 502, and in the same manner, alternately performs row-wise decoding or column-wise decoding on the third layer to the first layer in steps 503 to 505 to decode information bits. Further, as an optional example, it is also possible to alternately perform row-wise decoding or column-wise decoding in order from the first layer to the fifth layer in reverse order of FIG. 5(b) to decode information bits.

As a result of the encoding of the staircase code described above, a codeword of a very long length is generated and, when a part of the codeword experiences a burst error channel, decoding failure of the corresponding codeword may occur. To resolve such decoding failure, a hybrid automatic retransmission request (HARQ) used in a 5G NR system may be utilized. In this regard, retransmitting an entire codeword of the staircase code to recover from a decoding error in a specific component codeword has a negative impact in terms of resource utilization efficiency, decoding complexity, and delay.

Accordingly, if cyclic redundancy check (CRC) bits may be concatenated to each component codeword in each layer of the staircase code to detect an error, and only a specific codeword in which an error is detected may be retransmitted, the negative impact described above may be mitigated. Since a length of a component codeword constituting the staircase code is relatively short, retransmitting only a codeword in which an error is detected may realistically have many limitations. Further, adding individual CRC bits to each component codeword may lead to unnecessary resource utilization and may cause a loss in terms of a code rate.

As such, retransmitting an entire codeword or a specific component codeword of the staircase code has many problems. To solve such problems, embodiments of the disclosure propose various embodiments of using CRC for error detection of the staircase code but not adding CRC bits to an entire codeword or component codeword constituting the staircase code, and adding CRC bits to a set of new information bits in each single layer or a set of information bits of multiple layers during an encoding process of the staircase code.

Through embodiments of the disclosure, error detection using CRC on a single layer basis or a multiple layer basis of the staircase code is possible, unnecessary resource waste may be prevented thereby, and there is an advantage that error detection capability and utilization of a retransmission scheme are possible without significant loss in terms of a code rate. Further, by dynamically adjusting a length of CRC bits added on each layer or multiple layer basis of the staircase code, CRC bits of a relatively long length may be added to a specific layer having insufficient error detection capability or relatively low decoding performance. Further, in the disclosure, information bits may be protected using CRC bits for error correction rather than partial error detection. Hereinafter, adding CRC bits in each layer of the staircase code is referred to as CRC encoding. Further, the CRC bits may be referred to as a CRC code.

In the disclosure, a transmitting device may perform individual CRC encoding on each component codeword of the staircase code in the same manner as a CRC encoding method applied in an NR system. In this case, generated CRC bits may be attached to a rear part of existing information bits. A receiving device may perform error detection for each component codeword by performing individual CRC for each component codeword. A scope of CRC encoding may or may not include front M duplicated/overlapped bits of a component codeword (e.g., the duplicated/overlapped bits (hereinafter overlapped bits) may include information bits and parity bits already processed in a previous layer of the staircase code, or may be composed of only parity bits), and CRC encoding may also be performed on the overlapped bits, but in this case, since CRC encoding is also performed on parity bits that do not need protection, resource utilization efficiency may decrease. Whether to perform CRC encoding on the overlapping part of the staircase code described above may be selectively adjusted according to a channel environment or importance of resource utilization efficiency.

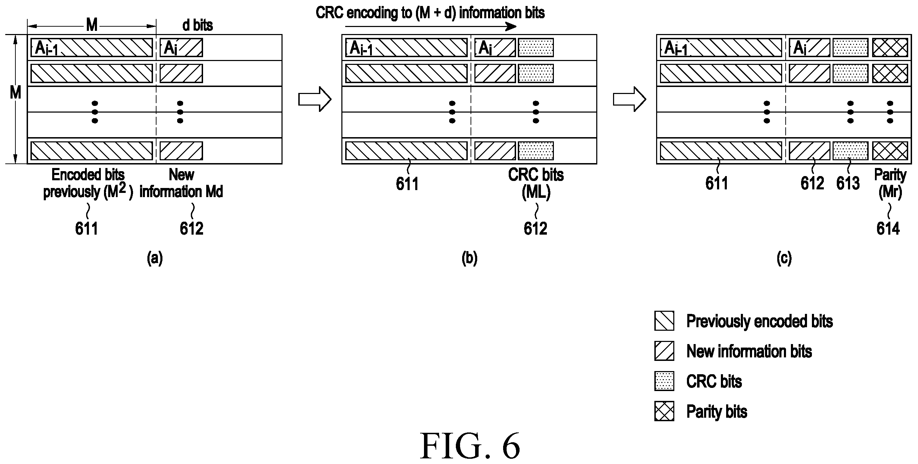

FIG. 6 is a view illustrating an example of an encoding method including CRC addition for a square matrix-based staircase code according to an embodiment of the disclosure.

The example of FIG. 6 illustrates row-wise CRC encoding in an ith layer including 2 square matrices Aᵢ₋₁, Aᵢ (where i is a layer index) having a size of M×M in a staircase code having multiple layers. The matrix Aᵢ₋₁ includes previously encoded bits 611 in an (i-1)th layer and corresponds to an overlapping part in the staircase code. In the ith layer, the matrix Aᵢ includes new information bits 612, CRC bits 613, and parity bits 614.

Operation 1: FIG. 6(a) illustrates an operation in which new information bits 612 are inserted into the matrix Aᵢ in the ith layer. In the matrix Aᵢ adjacent to the right of the matrix Aᵢ₋₁ including previously encoded bits 611 of M² bit number, new information bits 612 of M×d bit number are added in d columns. It is assumed that a number of new information bits inserted in each row is d. In this case, each row of the ith layer is composed of M+d information bits. As an optional embodiment, a position where new information bits 612 are added to the matrix Aᵢ₋₁ is not limited to the example of FIG. 6, and new information bits 612 may be added at various positions such as the right, left, or middle of the matrix Aᵢ₋₁.

Operation 2: FIG. 6(b) illustrates an operation in which CRC encoding of length L is performed on each row basis of the ith layer. L may be various lengths, and a CRC code for each length may be defined by a generator polynomial or a generator matrix. Through CRC encoding, each row of the ith layer may be composed of a total of *M + d + L* information bits including CRC bits 613 from a component code perspective. In FIG. 6(b), CRC encoding performed on a row basis in the ith layer is performed on information bits including previously encoded bits 611 in each row of the matrix Aᵢ₋₁ and new information bits 612 in each row of the matrix Aᵢ, and CRC bits 613 generated through CRC encoding are added to the right of new information bits 612 of the matrix Aᵢ.

Operation 3: FIG. 6(c) illustrates an operation in which encoding using a component code C such as an LDPC code, a polar code, or a BCH code is performed on each row basis of the ith layer. By performing encoding using a component code for a total of *M + d + L* information bits in each row of the ith layer, r parity bits 614 are generated, and each row may be filled with a total of (*M* + *d* + *L* + *r*) = 2*M* encoded bits. Parity bits 614 generated through encoding using a component code are added to the right of CRC bits 613 of the matrix Aᵢ.

The example of FIG. 6 illustrates row-wise encoding performed in the ith layer, and row-wise encoding and column-wise encoding in the staircase code may be alternately performed as described above. Column-wise encoding performed in the (i-1)th and (i+1)th layers may be performed in the same manner by substituting the row-wise operations of Operations 1 to 3 in the encoding method of FIG. 6 with column-wise operations. Further, the row-wise or column-wise encoding may be performed on a component codeword basis.

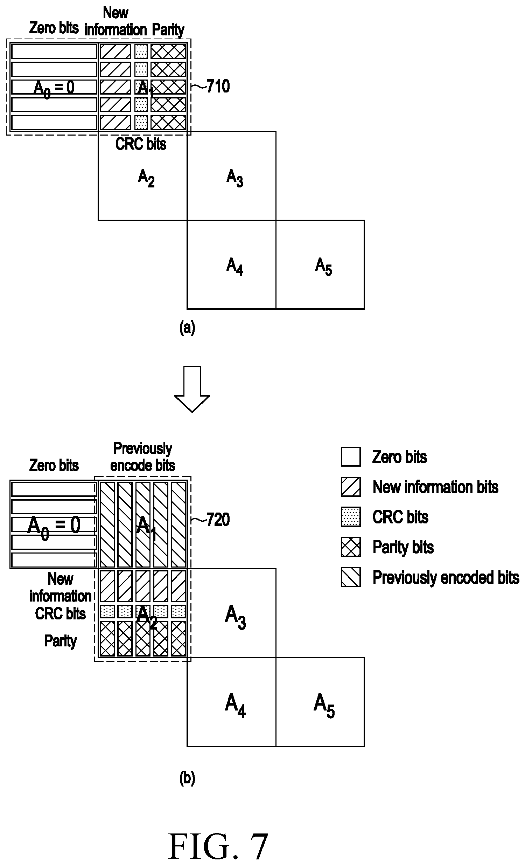

FIG. 7 is a view illustrating an example of an encoding method including CRC addition for a square matrix-based staircase code according to an embodiment of the disclosure.

The example of FIG. 7 illustrates an example in which the encoding method of FIG. 6 is performed on a staircase code composed of a plurality of square matrices A₀, A₁, A₂, A₃, A₄, A₅ having a size of M×M using a square matrix-based staircase code with a number of layers (k) of 5.

In FIG. 7(a), row-wise encoding may be performed on the matrices A₀, A₁ of the first layer 710 by applying the encoding method of FIG. 6. The matrix A₀ is an initial matrix filled with 0. Thereafter, in FIG. 7(b), column-wise encoding may be performed on the matrices A₁, A₂ of the second layer 720 by applying the encoding method of FIG. 6 on a column basis. In the same manner, row-wise encoding or column-wise encoding may be alternately performed on the remaining layers of the staircase code.

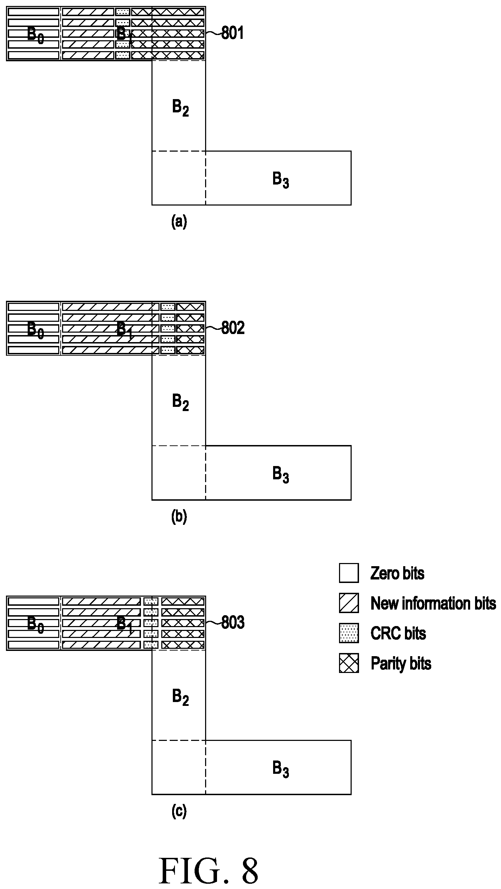

FIG. 8 is a view illustrating an example of an encoding method including CRC addition for a non-square matrix-based staircase code according to an embodiment of the disclosure.

The example of FIG. 8 illustrates an example in which the encoding method of FIG. 6 for CRC encoding is performed on a staircase code with a number of layers (k) of 3 composed of an initial matrix B₀ of M×M size and a plurality of non-square matrices B₁, B₂, B₃ of M×(N-M) or (N-M)×M size, similar to the examples of FIGS. 2A to 3. In the encoding method of the non-square matrix-based staircase code of FIG. 8, an operation in which new information bits are inserted into the matrix Bᵢ in the ith layer and an operation in which CRC encoding of length L is performed on each row or column basis of the ith layer may be applied in the same manner as Operations 1 and 2 in the encoding method of FIG. 6. Further, an operation in which encoding using a component code C such as an LDPC code, a polar code, or a BCH code is performed on each row or column basis of the ith layer may be applied in the same manner when a value of (*M* + *d* + *L* + *r*) representing a number of encoded bits in Operation 3 of the encoding method of FIG. 6 is set to a code length N_{C} of a component codeword instead of 2M.

FIGS. 8(a), (b), and (c) illustrate various combination examples of information bits, CRC bits, and parity bits included in overlapping parts 801, 802, 803 between adjacent layers according to a code rate of a component codeword in each layer of the staircase code. FIG. 8(a) illustrates a case where only parity bits are included in the overlapping part 801, FIG. 8(b) illustrates a case where information bits, CRC bits, and parity bits are included in the overlapping part 802, and FIG. 8(c) illustrates a case where CRC bits and parity bits are included in the overlapping part 803. As in the example of FIG. 8, an overlapping part between adjacent layers of the staircase code may further include information bits in the overlapping part 802 when increasing a code rate such as a code rate and an error rate during decoding, and may further include CRC bits and/or parity bits in the overlapping part 803 to lower the error rate when the error rate during decoding is high.

In the embodiments of FIGS. 6 to 8 above, CRC bits were added by performing row-wise or column-wise CRC encoding on information bits including previously encoded bits and new information bits in each layer in an encoding method of a square matrix-based or non-square matrix-based staircase code, but in the following embodiments, a CRC encoding method of adding CRC bits by performing row-wise or column-wise CRC encoding on new information bits except for previously encoded bits in each layer is described. As such, CRC encoding using new information bits in a staircase code according to the disclosure is referred to as layer-based CRC encoding.

The layer-based CRC encoding performs CRC encoding on a set of information bits newly added in each layer of the staircase code during an encoding process of the staircase code. In this case, generated CRC bits are attached to the right column(s) of information bits. A receiving device receiving a staircase code encoded through the layer-based CRC encoding may perform layer-based error detection by performing CRC for each specific layer basis. As an optional embodiment, an overlapping part between adjacent layers in a staircase code to which the layer-based CRC encoding is applied may or may not include information bits (e.g., information bits encoded in a previous layer) or parity bits. When performing CRC encoding on new information bits in each layer of the staircase code as such, a method of reading the corresponding information bits when converting to a row vector has no effect on encoding/decoding performance, so the corresponding information bits may be read in various methods such as row-first or column-first to perform CRC encoding. As an optional embodiment, the layer-based CRC encoding may be performed as single-layer-based CRC encoding or multi-layer-based CRC encoding.

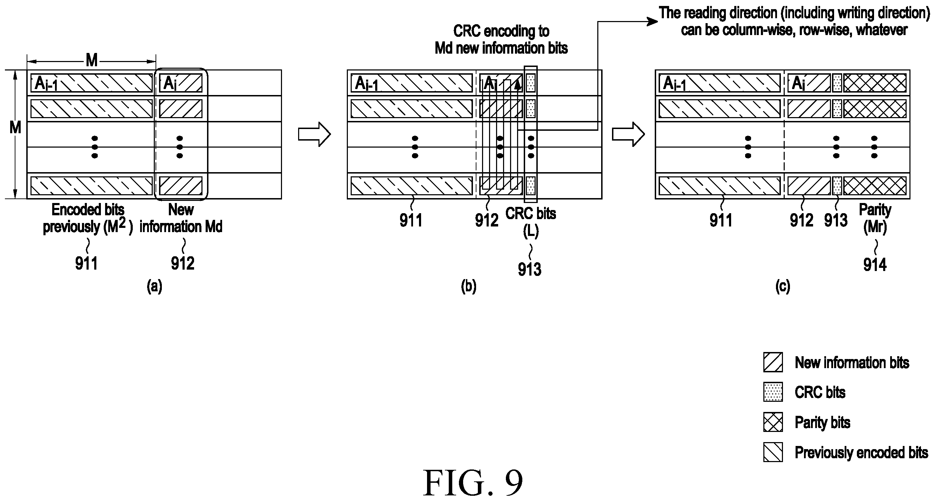

FIG. 9 is a view illustrating an example of an encoding method including CRC addition for a square matrix-based staircase code according to an embodiment of the disclosure. The example of FIG. 9 illustrates single-layer-based CRC encoding.

The example of FIG. 9 illustrates row-wise CRC encoding in an ith layer including 2 square matrices Aᵢ₋₁, Aᵢ (where i is a layer index) having a size of M×M in a staircase code having multiple layers. The matrix Aᵢ₋₁ includes previously encoded bits 911 in an (i-1)th layer and corresponds to an overlapping part in the staircase code. In the ith layer, the matrix Aᵢ includes new information bits 912, CRC bits 913, and parity bits 914.

Operation 1: FIG. 9(a) illustrates an operation in which new information bits 912 are inserted into the matrix Aᵢ in the ith layer. In the matrix Aᵢ adjacent to the right of the matrix Aᵢ₋₁ including previously encoded bits 911 of M² bit number, new information bits 912 of M×d bit number are added in d columns. It is assumed that a number of new information bits inserted in each row is d. In this case, each row of the ith layer is composed of M+d information bits. As an optional embodiment, a position where new information bits 912 are added to the matrix Aᵢ₋₁ is not limited to the example of FIG. 9, and new information bits 912 may be added at various positions such as the right, left, or middle of the matrix Aᵢ₋₁.

Operation 2: FIG. 9(b) illustrates an operation in which CRC encoding of length L' is performed on each row basis of the ith layer. L' may be various lengths, and a CRC code for each length may be defined by a generator polynomial or a generator matrix. Through CRC encoding, each row of the ith layer may be composed of a total of *M + d* + *L*' information bits including CRC bits 913 from a component code perspective. Here, a length of L' may be set in various ways, and specific examples is described below. In FIG. 9(b), CRC encoding in the ith layer may be performed on a set or entirety of new information bits 912 of the matrix Aᵢ, except for previously encoded bits 911 of the matrix Aᵢ₋₁. CRC encoding on a set or entirety of new information bits 912 may be performed on a set or entirety of bits read while increasing or decreasing a row index in each column through row vector conversion in columns where new information bits 912 are inserted, as illustrated by arrows in FIG. 9(b). CRC bits 913 generated through CRC encoding are added to the right of new information bits 913 of the matrix Aᵢ.

Operation 3: FIG. 9(c) illustrates an operation in which encoding using a component code C such as an LDPC code, a polar code, or a BCH code is performed on each row basis of the ith layer. By performing encoding using a component code for a total of *M + d* + *L*' information bits in each row of the ith layer, r parity bits 914 are generated, and each row may be filled with a total of (*M + d* + *L'* + *r*) = 2*M* encoded bits. Parity bits 914 generated through encoding using a component code are added to the right of CRC bits 913 of the matrix Aᵢ.

The example of FIG. 9 illustrates row-wise encoding performed in the ith layer, and row-wise encoding and column-wise encoding in the staircase code may be alternately performed as described above. Column-wise encoding performed in the (i-1)th and (i+1)th layers may be performed in the same manner by substituting the row-wise operations of Operations 1 to 3 in the encoding method of FIG. 9 with column-wise operations. Further, the row-wise or column-wise encoding may be performed on a component codeword basis.

In the embodiment of FIG. 9, the encoding method generating a CRC code using a set of new information bits except for previously encoded bits in each layer of the staircase code may generate a CRC code with a relatively smaller number of bits compared to the CRC encoding method of FIG. 6. In this case, since parity bits may be generated with a relatively larger number of bits in each layer, decoding performance may be enhanced while reducing a code rate loss. Further, the CRC encoding method of FIG. 9 may be applied in the same manner to a non-square matrix-based staircase code.

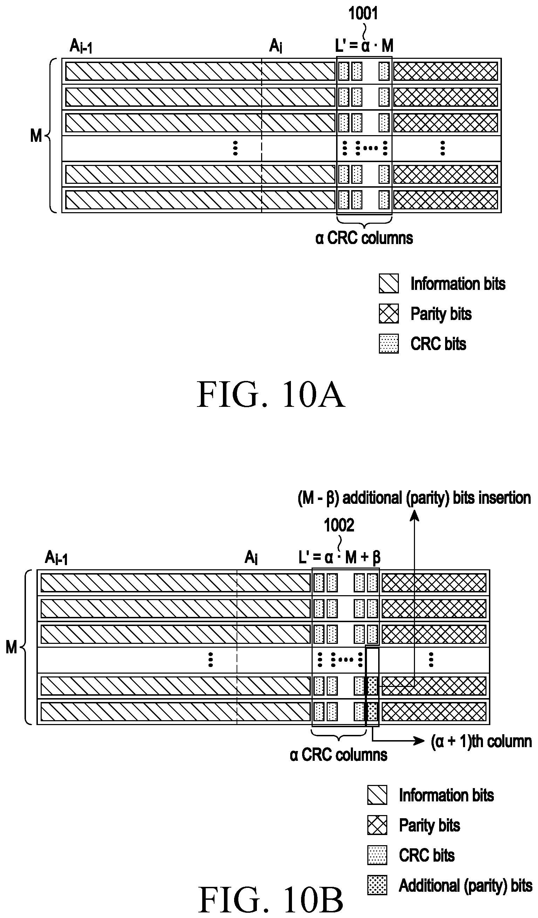

FIGS. 10A to 10C illustrate various methods of adjusting a length L' of a CRC code in an encoding method including CRC addition for a square matrix-based staircase code according to an embodiment of the disclosure.

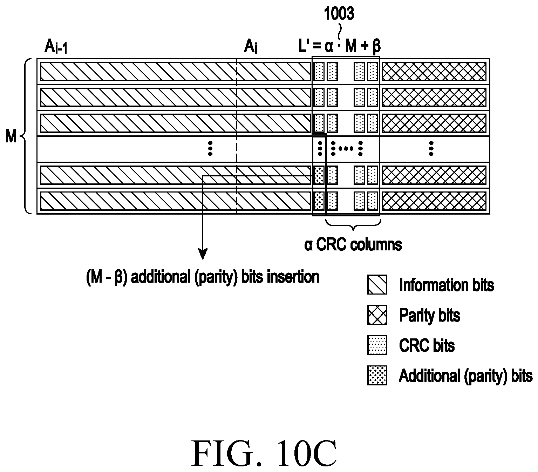

When a length of a CRC code is L', when comparing L' with a number M of rows of a square matrix, the example of FIG. 10A is for a case where L' is divisible by M (i.e., L^{'} = α · M). The examples of FIGS. 10B and 10C are for a case (L^{'} = α · *M* + β where 0 < *β* < *M*) where L' is not divisible by M.

Looking at a structure of each layer of the staircase code in FIGS. 10A to 10C, each layer includes matrices Aᵢ₋₁, Aᵢ (where i is a layer index) of M×N size, and M columns of the left matrix Aᵢ₋₁ are bits previously processed in the (i-1)th layer and bits to be used as information bits in the ith layer. New information bits are inserted in d columns from the leftmost of the right matrix Aᵢ, and a CRC code (bits) of length L' generated through CRC encoding on a set of new information bits is added to the right column(s) (hereinafter CRC column(s)) adjacent to the d columns of the right matrix Aᵢ. Parity bits are added to the rightmost r columns of the right matrix Aᵢ.

FIG. 10A illustrates a case 1001 where a length L' of a CRC code is equal to an integer multiple of a number M of rows of a square matrix (or a case where L is divisible by M), and CRC column(s) of the matrix Aᵢ may all be filled with CRC bits. In this case, L= α·M parity bits generated by CRC encoding are added to the α CRC column(s) of (α 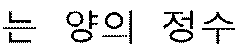 , α=1, 2, 3....) immediately to the right of columns where new information bits of (*M* × *d*) size are inserted in the matrix Ai. As a result, a relationship of N=M+d+ α +r is established.

FIGS. 10B and 10C illustrate cases 1002, 1003 where a length L' of a CRC code is not divisible by a number M of rows of a square matrix. In the cases of FIGS. 10B and 10C, since CRC bits generated through CRC encoding fill (α - 1) CRC columns of the matrix Aᵢ and then may not fill all of the last α-th CRC column (as in the examples of FIGS. 10B and 10C, β remaining CRC bits are filled in the parity part), an empty space (area) is generated in (M-L') row(s) in the CRC column(s). In the empty space (area), e.g., additional (parity) bits or information bits may be inserted. The (M - β) additional (parity) bits may be inserted. The additional (parity) bits may be parity bits using a component code, even parity bits, or zero bits. When parity bits using a component code are inserted, parameter(s) of a component code may be changed for (M - β) rows and, when even parity bits are inserted, 1-bit even parity bits generated based on new information bits may be inserted in the corresponding row. When zero bits are inserted, the empty space may be simply filled.

When inserting information bits in the empty space, new information bits or previously inserted information bits may be inserted by repetition in the empty space. In this case, since a codeword of a row in which CRC bits are inserted and a codeword of row(s) in which CRC bit(s) are not inserted have the same number of information bits in encoding of a component code, the same encoding strategy may be used.

As an optional embodiment, when inserting additional (parity) bits (or null bits) in the empty space, Method 1, Method 2, or Method 3 below may be used.

### Method 1: Parity bit insertion of component code

By adjusting a code rate in the row(s) where the empty space is generated, at least one more parity bit may be generated than in other rows. In this case, a code rate may be finely adjusted. Method 1 may be used when preset information bits are limited.

### Method 2: Zero padding

Value(s) of 0 are inserted in the empty space by nulling. In this case, since a receiving device may know in advance through system parameters for the staircase code that the empty space is filled with null bit(s), when using a systematic code, decoding is possible by inserting a maximum reliability value, and a performance gain may be expected therefrom.

### Method 3: Parity bit insertion

Even parity bit(s) may be generated using information bits in the corresponding row(s) where the empty space is generated in the matrix Aᵢ and inserted in the empty space.

The various methods of adjusting a length L' of a CRC code in the embodiments of FIGS. 10A to 10C above may also be applied in the same manner to a non-square matrix-based staircase code.

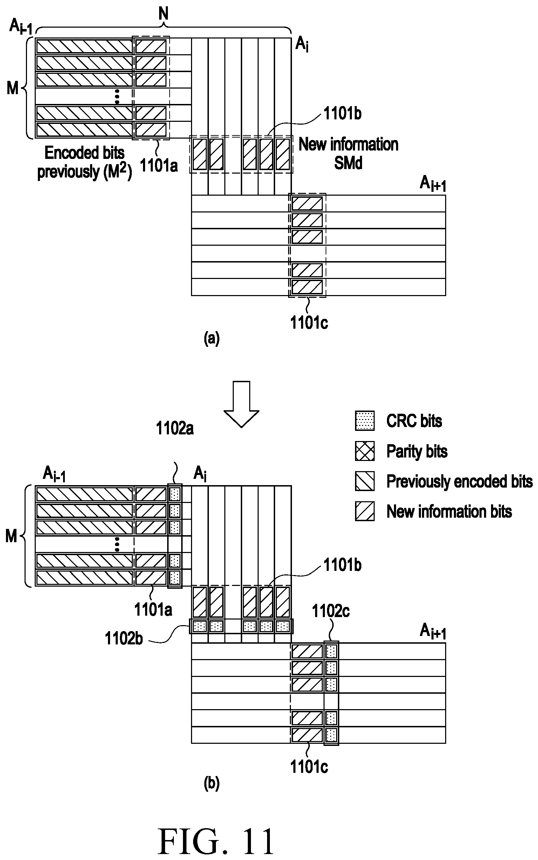

FIG. 11 is a view illustrating an example of an encoding method including CRC addition for a non-square matrix-based staircase code according to an embodiment of the disclosure. The example of FIG. 11 illustrates multi-layer-based CRC encoding.

FIG. 11 illustrates a non-square matrix-based staircase code with a number of layers (k) of 3 or more. For example, a staircase code composed of a plurality of non-square matrices Bᵢ₋₁, Bᵢ, Bᵢ₋₁ of M×(N-M) or (N-M)×M size includes an overlapping part of M×M size between adjacent layers. In the example of FIG. 11, the overlapping part may include, e.g., previously encoded bits.

In FIG. 11(a), the staircase code includes, e.g., S (S=3 in FIG. 11) new information parts 1101a, 1101b, 1101c in units where multi-layer-based CRC encoding may be performed. In FIG. 11(b), CRC parts 1102a, 1102b, 1102c are added adjacent to new information parts 1101a, 1101b, 1101c in the corresponding layer, respectively. In this embodiment, CRC parts 1102a, 1102b, 1102c may be generated by performing one CRC encoding on a set of S new information parts 1101a, 1101b, 1101c. The entire CRC bits generated as such may be divided into S CRC parts 1102a, 1102b, 1102c and added adjacent to the corresponding new information part in each layer. As in the example of FIG. 11, CRC encoding may be performed on a plurality of layers basis. As an example, when a total number of layers of the staircase code is 30 and S=3, which is a plurality of layers basis on which CRC encoding is performed, CRC encoding may be performed once for every 3 layers, so a total of 10 CRC encodings may be performed. When performing CRC encoding by the method of FIG. 11, a receiving device may detect an error by performing CRC on a multi-layer basis. Further, when performing single-layer-based CRC encoding as in the embodiment of FIG. 9, indices for distinguishing CRC bits are needed for each layer of the staircase code, but when performing multi-layer-based CRC encoding as in the embodiment of FIG. 11, CRC bits may be distinguished for each plurality of layers, so a number of indices for distinguishing CRC bits may be decreased. This enables efficient CRC encoding/decoding at a transmitting device and a receiving device using a staircase code.

As an optional embodiment, an overlapping part between adjacent layers in a staircase code to which multi-layer-based CRC encoding is applied may or may not include information bits (e.g., information bits in a previous layer) or parity bits. When performing CRC encoding on new information bits on a multi-layer basis of the staircase code, a method of reading the corresponding information bits when converting to a row vector has no effect on encoding/decoding performance, so the corresponding information bits may be read in various methods such as row-first or column-first to perform CRC encoding.

The method of FIG. 11 described above may also be applied in the same manner to multi-layer-based CRC encoding based on a square matrix.

Specifically describing the multi-layer-based CRC encoding method, when a number of layers on which CRC encoding is performed at once is S, a generation process of the *i*, *i* + 1, ... i + *S* - 1-th layers is as follows in Operations 1), 2), and 3). It is assumed that a number of new information bits in each row of each layer is d.

Operation 1): In FIG. 11, new information bits may be inserted into the matrix Bᵢ in the ith layer. In the matrix Bᵢ(*i* = *i*, *i* + 1, ..., *i* + *S* - 1 ) of each layer, M×d new information bits are newly added in the right d columns adjacent to the matrix Bᵢ₋₁ of M×M size including information bits encoded in the (i-1)th layer. In this case, each row includes M+d information bits. In this case, a direction of adding new information bits is not limited to the example of FIG. 11, and new information bits 912 may be added at various positions such as the right, left, or middle of the matrix Aᵢ₋₁.

Operation 2): In FIG. 11, CRC encoding of length L' may be performed on a plurality of layers basis. CRC encoding adding a CRC code of length L' is performed on S(M×d) new information bits. In this case, CRC encoding is performed on a plurality of layers basis as described in the example of FIG. 11. CRC bits generated through one CRC encoding may be divided into S CRC parts and added adjacent to the corresponding new information bits (information part) in each layer. L' may be various lengths, and a CRC code for each length is defined by a generator polynomial or a generator matrix. Through CRC encoding, each row may be composed of a total of $M + d + L ′ \left(L′=\frac{L}{SM}\right)$ information bits from a component code perspective. In this case, a length of L' may be adjusted as illustrated in the embodiments of FIGS. 10A to 10C.

Operation 3): Encoding using a component code C such as an LDPC code, a polar code, or a BCH code may be performed on each row or column basis of the ith layer. By performing encoding using a component code for a total of *M + d* + *L'* information bits for each row or column of the ith layer, r parity bits are generated, and each row may be filled with a total of (*M + d* + *L*' + *r*) = *N_{c}* encoded bits. Parity bits generated through encoding using a component code may be added to the right of CRC bits of the matrix Bᵢ. A receiving device may detect an error through individual CRC on a multi-layer basis.

As an optional embodiment, in the multi-layer-based CRC encoding, when a total number of layers k is not a multiple of S, which is a number (unit) of layers on which one CRC encoding is performed, e.g., *α* = *k* mod*S* layer(s) may remain. In this case, it is also possible to perform CRC encoding only on information bits of α layer(s).

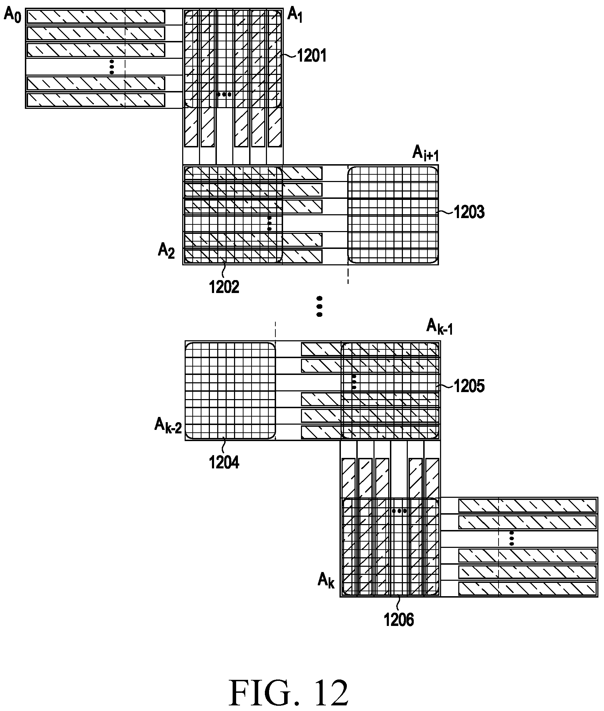

FIG. 12 is a view illustrating a method of adjusting a length of a CRC code by considering a number of overlapping parts in each layer in a staircase code according to an embodiment of the disclosure.

Referring to FIG. 12, a square or non-square matrix-based staircase code with a number of layers of k is illustrated. A staircase code composed of non-square matrices B₀, B₁, B₂, ..., Bₖ₋₂, Bₖ₋₁, Bₖ constituting the staircase code includes overlapping parts 1201, 1202, 1203, ..., 1204, 1205, 1206 between adjacent layers. The overlapping parts may include, e.g., bits encoded in a previous layer. In FIG. 12, due to structural characteristics of the staircase code, the matrix B₀ of the first layer and the matrix Bₖ of the last layer include only one overlapping part unlike other layers located in the middle, and the other layers may include two overlapping parts. Since the overlapping part includes encoded bits of another layer, information of another adjacent layer may be obtained through the overlapping part during decoding. Since the first layer and the last layer in the staircase code each include only one overlapping part, decoding performance and/or error detection performance may be relatively lower compared to other layers. If a length of a CRC code in the first layer and the last layer is adjusted to be longer compared to a length of a CRC code in other layers, error detection performance in the first layer and the last layer may be further enhanced. As an optional embodiment, decoding performance and/or error detection performance of the staircase code may be enhanced by selectively decreasing or increasing a length of a CRC code in layers other than the first layer and the last layer.

In the embodiments of the disclosure described above, a total number of information bits and a code rate of the staircase code may be determined or negotiated in various ways through signaling between a transmitting device and a receiving device in a communication system. For example, assuming that the transmitting device is a base station and the receiving device is a terminal, or vice versa is also possible. The transmitting device may provide first control information related to encoding of the staircase code to the receiving device in advance, for example. The first control information related to encoding may be information indicating/representing at least one of parameters in Table 1 above. As an optional embodiment, the first control information may correspond to MCS information. In this case, the first control information may be stored/provided in advance as, e.g., table information to the transmitting device and the receiving device, and the transmitting device and the receiving device may check encoding-related parameters of the staircase code corresponding to MCS information from the table information and perform encoding and decoding operations.

As an optional embodiment, among encoding-related parameters of the staircase code, a number of layers k and a number of rows/columns M of each layer may be variously determined according to requirements such as decoding performance or system delay, since they determine a total code length Nₜₒₜ and a total number of information bits Kₜₒₜ, which greatly affect encoding/decoding performance and complexity. Here, Nₜₒₜ and Kₜₒₜ may use predetermined information. A receiving device receiving a signal encoded using a staircase code may, after receiving the first control information, transmit second control information related to encoding of the staircase code indicating adjusted encoding-related parameters to the transmitting device when adjustment of at least one of encoding-related parameters (Nₜₒₜ, Kₜₒₜ, k, M) is needed based on a channel environment, requirements, a current available resource size, or the like. The transmitting device may perform encoding of the staircase code using parameters adjusted based on the second control information and transmit an encoded signal to the receiving device. The receiving device may decode a received signal based on encoding-related parameters in the first control information or the second control information. At least one of transmission/reception operations of the first control information and the second control information between the transmitting device and the receiving device may be selectively performed. The first control information and the second control information may be transmitted and received between the transmitting device and the receiving device through at least one of system information, RRC (Radio Resource Control) information, MAC-CE (Medium Access Control-Control Element), and DCI (Downlink Control Information) information.

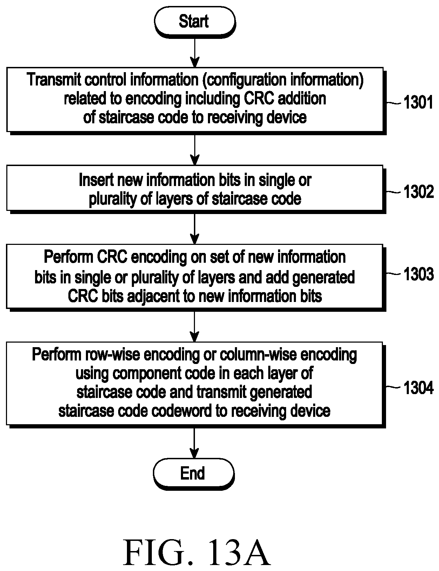

FIG. 13A is a view illustrating an encoding method including CRC addition for a staircase code performed by a transmitting device of a wireless communication system according to an embodiment of the disclosure. The encoding method including CRC addition may be performed using at least one of the embodiments of FIGS. 6 to 12. The staircase code of FIG. 13A may be applied to both a square matrix-based staircase code and a non-square matrix-based staircase code.

Referring to FIG. 13A, in step 1301, the transmitting device may transmit control information (configuration information) related to encoding including CRC addition of the staircase code described in the embodiments of FIGS. 6 to 12 to the receiving device. The configuration information may include at least one of parameters in Table 1, or information indicating/representing the at least one parameter, or information corresponding to the at least one parameter. When the transmitting device and the receiving device store or know in advance the encoding-related parameters of the staircase code, step 1301 may be omitted.

In step 1302, the transmitting device inserts/places/adds new information bits in a single or a plurality of layers of the staircase code.

In step 1303, the transmitting device performs CRC encoding on the set of the new information bits in the single or the plurality of layers and adds generated CRC bits adjacent to the new information bits. When CRC encoding is performed on a single layer basis, CRC encoding may be performed on a layer-by-layer basis for the set of the new information bits except for bits encoded in a previous layer. When CRC encoding is performed on a plurality of layers basis, one CRC encoding is performed on an entirety of the set of the new information bits in the plurality of layers except for bits encoded in previous layer(s), generated CRC bits are divided by the number of the plurality of layers, and divided CRC bits may be added to each layer of the plurality of layers.

In step 1303, CRC encoding is not performed on an overlapping part between adjacent layers of the staircase code. As an optional embodiment, a length (L') of CRC bits (i.e., CRC code) generated through CRC encoding may be the same in all layers of the staircase code or may be adjusted differently in at least one layer among the all layers. When the length (L') of the CRC code is adjusted differently in the at least one layer, an empty space (area) may be generated in the corresponding layer, and the empty space (area) may be filled with an information bit, a parity bit, or a null bit.

In step 1304, the transmitting device performs row-wise encoding or column-wise encoding using a component code C on bits including previously encoded bits, new information bits, and CRC bits in each layer of the staircase code, adds generated parity bits to the corresponding layer to generate a component codeword, and may transmit a staircase code codeword composed of generated multiple component codewords to the receiving device.

As an optional embodiment, although not illustrated in FIG. 13A, after the transmitting device transmits the control information (configuration information) related to encoding to the receiving device, the transmitting device may receive control information related to encoding determined/adjusted by the receiving device based on a channel environment, requirements, a current available resource size, or the like from the receiving device. In this case, the transmitting device may perform an encoding method including CRC addition for a staircase code based on the determined/adjusted control information related to encoding.

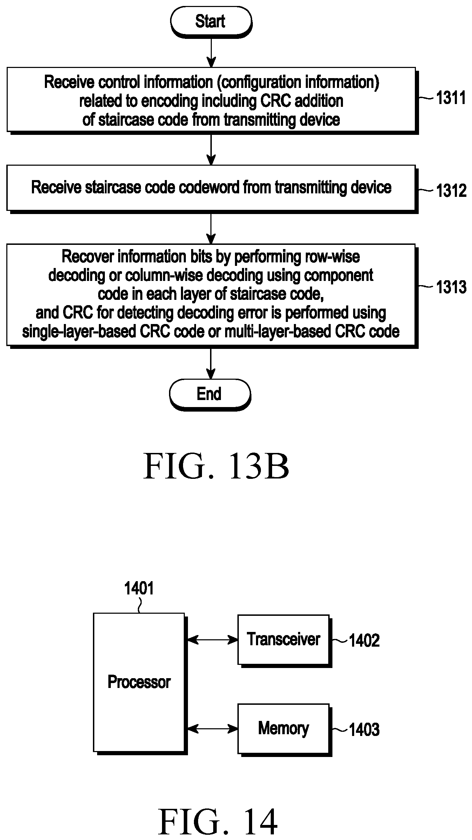

FIG. 13B is a view illustrating a decoding method for a staircase code performed by a receiving device of a wireless communication system according to an embodiment of the disclosure. The staircase code of FIG. 13B may be applied to both a square matrix-based staircase code and a non-square matrix-based staircase code.

Referring to FIG. 13B, in step 1311, the receiving device may receive control information (configuration information) related to encoding including CRC addition of the staircase code from the transmitting device. In step 1312, the receiving device may receive an encoded staircase code codeword from the transmitting device. Further, in step 1313, the receiving device may recover information bits by performing row-wise decoding or column-wise decoding using a component code in each layer of the staircase code. The receiving device may perform CRC for detecting a decoding error in a decoding process using a single-layer-based CRC code or a multi-layer-based CRC code.

As an optional embodiment, although not illustrated in FIG. 13B, after the receiving device receives the control information (configuration information) related to encoding from the transmitting device, the receiving device may transmit control information related to encoding determined/adjusted by the receiving device based on a channel environment, requirements, a current available resource size, or the like to the transmitting device. In this case, the receiving device may receive an encoded staircase code codeword from the transmitting device based on the determined/adjusted control information related to encoding.

As an optional embodiment, whether encoding including CRC addition of the staircase code is performed on a single layer basis or a plurality of layers basis may be notified by the transmitting device to the receiving device through configuration information or may be predetermined between the transmitting device and the receiving device.

Through the embodiments of the disclosure described above, an encoded signal may be transmitted by adding a CRC code during encoding of the staircase code. A CRC code may be effectively applied to retransmission using HARQ. Further, CRC encoding may be performed as single-layer-based CRC encoding or multi-layer-based CRC encoding as described above, and retransmission using HARQ may also be performed on a single layer basis or a multi-layer basis, so resource utilization efficiency may be increased. Further, the CRC encoding method using a set of new information bits in the disclosure may enhance decoding performance while reducing a code rate loss, and may enhance error detection capability for a layer having relatively low error detection performance by dynamically adjusting a CRC length for each layer of the staircase code.

FIG. 14 is a view illustrating an example configuration of a communication device in a wireless communication system according to an embodiment of the disclosure. The communication device may be a transmitting device performing the encoding method of the staircase code described above or a receiving device performing the decoding method of the staircase code described above. Further, the communication device of FIG. 14 may be one of a base station and a terminal.

The communication device of FIG. 14 may include a processor 1401, a transceiver 1403, and memory 1405. The processor 1401, the transceiver 1403, and the memory 1405 of the communication device may operate according to the encoding/decoding method of the staircase code described in the embodiments of FIGS. 1A to 13B. However, components of the communication device are not limited to the examples described above. For example, the communication device may include more components or fewer components than the components described above. Further, the processor 1401, the transceiver 1403, and the memory 1405 may also be implemented in the form of a single chip.

The transceiver 1403 is a collective term for a receiver and a transmitter of the communication device and may transmit/receive a signal with a counterpart communication device. In this case, a signal transmitted and received may include at least one of control information and data. Further, the transceiver 1403 may receive a signal and output it to the processor 1401, and may transmit a signal output from the processor 1401. Further, the transceiver 1403 of FIG. 14 may include an RF transmitter that up-converts and amplifies a frequency of a signal to be transmitted, and an RF receiver that low-noise amplifies a received signal and down-converts a frequency. Further, the transceiver 1403 may receive a signal and output it to the processor 1401, and may transmit a signal output from the processor 1401 to a counterpart communication device through a network. The memory 1405 may store a program and data necessary for performing the encoding/decoding method of the staircase code described in the embodiments of FIGS. 1A to 13B. The memory 1405 may store control information or data included in a signal obtained at the communication device. The memory 1405 may be composed of a storage medium such as ROM, RAM, hard disk, CD-ROM, DVD, or a combination of storage media. Further, the processor 1401 may control a series of processes so that the communication device may operate according to at least one of the embodiments of FIGS. 1A to 13B. The processor 1401 may include at least one processor.

The methods according to the embodiments descried in the specification or claims of the disclosure may be implemented in hardware, software, or a combination of hardware and software. When implemented in software, there may be provided a computer readable storage medium storing one or more programs (software modules). One or more programs stored in the computer readable storage medium are configured to be executed by one or more processors in an electronic device. One or more programs include instructions that enable the electronic device to execute methods according to the embodiments described in the specification or claims of the disclosure.

The programs (software modules or software) may be stored in random access memories, non-volatile memories including flash memories, read-only memories (ROMs), electrically erasable programmable read-only memories (EEPROMs), magnetic disc storage devices, compact-disc ROMs, digital versatile discs (DVDs), or other types of optical storage devices, or magnetic cassettes. Or, the programs may be stored in memory constituted of a combination of all or some thereof. As each constituting memory, multiple ones may be included. The programs may be stored in attachable storage devices that may be accessed via a communication network, such as the Internet, Intranet, local area network (LAN), wide area network (WAN), or storage area network (SAN) or a communication network configured of a combination thereof. The storage device may connect to the device that performs embodiments of the disclosure via an external port. A separate storage device over the communication network may be connected to the device that performs embodiments of the disclosure.

In the above-described specific embodiments, the components included in the disclosure are represented in singular or plural forms depending on specific embodiments proposed. However, the singular or plural forms are selected to be adequate for contexts suggested for ease of description, and the disclosure is not limited to singular or plural components. As used herein, the singular forms "a," "an," and "the" are intended to include the plural forms as well, unless the context clearly indicates otherwise.

Although specific embodiments of the disclosure have been described above, various changes may be made thereto without departing from the scope of the disclosure. Thus, the scope of the disclosure should not be limited to the above-described embodiments, and should rather be defined by the following claims and equivalents thereof.

## Claims

1. A method of encoding, including cyclic redundancy check (CRC) addition of a staircase code, performed by a transmitting device in a wireless communication system, the method comprising:
inserting new information bits in a single layer or a plurality of layers of the staircase code;
performing CRC encoding on a set of new information bits in the single layer or the pluralityof layers and adding generated CRC bits to the new information bits; and
transmitting a staircase code codeword generated by performing row-wise encoding or column-wise encoding using a component code in each layer of the staircase code to a receiving device.

2. The method of claim 1, wherein, in case that the CRC encoding is performed in the single layer, the CRC encoding is performed on a layer-by-layer basis for the set of the new information bits except for bits encoded in a previous layer of the single layer.

3. The method of claim 1, wherein, in case that the CRC encoding is performed in the plurality of layers, the CRC encoding is performed for the set of the new information bits except for bits encoded in previous layers of the plurality of layers.

4. The method of claim 3, wherein the adding comprises:
performing one CRC encoding for an entirety of the set of the new information bits in the plurality of layers;
dividing the CRC bits by a number of the plurality of layers; and
adding the divided CRC bits to each layer of the plurality of layers.

5. The method of claim 1, wherein a length of the CRC bits is the same in all layers of the staircase code or is adjusted differently in at least one layer among the all layers.

6. The method of claim 5, wherein, in case that the length of the CRC bits is adjusted differently in the at least one layer and an empty space is generated, the empty space is filled with an information bit, a parity bit, or a null bit, based on the length of the CRC bits and a number of rows in a matrix of the staircase code.

7. The method of claim 1, wherein the staircase code uses one of a square matrix-based staircase code and a non-square matrix-based staircase code, each layer in the staircase code includes at least one matrix, and the staircase code includes at least one overlapping part between adjacent layers.

8. The method of claim 1, further comprising:
transmitting encoding-related configuration information including the CRC addition of the staircase code to the receiving device, wherein the CRC encoding is performed based on the configuration information,
wherein the configuration information includes at least one of information on the component code, a number of layers of the staircase code, a number of information bits of a component codeword, a code length of the component codeword, a total number of information bits of a staircase code codeword, a total code length of the staircase code codeword, a number of parity bits of the component codeword, and a length of the CRC bits.

9. The method of claim 1, further comprising:
receiving encoding-related control information including the CRC addition of the staircase code from the receiving device, wherein the CRC encoding is performed based on the control information,
wherein the control information includes at least one of information on the component code, a number of layers of the staircase code, a number of information bits of a component codeword, a code length of the component codeword, a total number of information bits of a staircase code codeword, a total code length of the staircase code codeword, a number of parity bits of the component codeword, and a length of the CRC bits.

10. A transmitting device performing encoding, including cyclic redundancy check (CRC) addition of a staircase code, in a wireless communication system, the transmitting device comprising:
a transceiver; and
a processor configured to:
insert new information bits in a single layer or a plurality of layers of the staircase code;
perform CRC encoding on a set of new information bits in the single layer or the plurality of layers and add generated CRC bits to the new information bits; and
transmit, through the transceiver, a staircase code codeword generated by performing row-wise encoding or column-wise encoding using a component code in each layer of the staircase code to a receiving device.

11. The transmitting device of claim 10, adapted to operate according to the method of any one of claims 2 through 9.

12. A method of decoding a staircase code performed by a receiving device in a wireless communication system, the method comprising:
receiving, from a transmitting device, encoding-related configuration information including cyclic redundancy check (CRC) addition of the staircase code;
receiving an encoded staircase code codeword from the transmitting device; and
recovering information bits by performing row-wise decoding or column-wise decoding using a component code in each layer of the staircase code based on the configuration information,
wherein a decoding error for the staircase code codeword is detected using a single-layer-based CRC code or a multi-layer-based CRC code.

13. The method of claim 12, wherein the staircase code uses one of a square matrix-based staircase code and a non-square matrix-based staircase code, each layer in the staircase code includes at least one matrix, and the staircase code includes at least one overlapping part between adjacent layers.

14. A receiving device performing decoding of a staircase code in a wireless communication system, the receiving device comprising:
a transceiver; and
a processor configured to:
receive, through the transceiver, encoding-related configuration information including cyclic redundancy check (CRC) addition of the staircase code from a transmitting device;
receive, through the transceiver, an encoded staircase code codeword from the transmitting device;
recover information bits by performing row-wise decoding or column-wise decoding using a component code in each layer of the staircase code based on the configuration information; and
detect a decoding error for the staircase code codeword using a single-layer-based CRC code or a multi-layer-based CRC code.

15. The receiving device of claim 14, wherein the staircase code uses one of a square matrix-based staircase code and a non-square matrix-based staircase code, each layer in the staircase code includes at least one matrix, and the staircase code includes at least one overlapping part between adjacent layers.
